# EUROPEAN PATENT APPLICATION

(11) **EP 4 199 178 A1**
(43) Date of publication of application: **21.06.2023**
(21) Application number: 22213806.7
(22) Date of filing: 15.12.2022
(51) Int. Cl.: H01M 10/42, H01M 10/46, G01R 31/36

(54) **JIG FOR BATTERY CHARGING AND DISCHARGING TEST**

(30) Priority: 16.12.2021 KR 20210180224
(71) Applicant: WONIK PNE CO., LTD., Suwon-si, Gyeonggi-do 16648 (KR)
(72) Inventor: KIM, Sockjun, 16648 Suwon-si, Gyeonggi-do (KR); CHOI, Yonghwan, 16648 Suwon-si, Gyeonggi-do (KR)
(74) Representative: Stöckeler, Ferdinand

(57) **Abstract**

The present disclosure relates to a jig for a battery charging and discharging test, and includes a jig body 100 in which a battery is mounted and the battery charging and discharging test is performed, in which the jig body 100 includes four terminal units 130a, 130b, 130c, and 130d that are cross-arranged to face different poles and a bus bar that connects the two units 130a and 130c of the four terminal units 130a, 130b, 130c, and 130d to power supply units 161 and 162 crosswise to support the two units 130a and 130c and connects the other two terminal units 130b and 130d to the power supply units 161 and 162 horizontally to support the other two terminal units 130b and 130d.. According to the present disclosure, since a battery may be accurately fixed and the bus bar accommodates movement of four terminal units, it is possible to easily fix a battery pack and increase the convenience of an operator performing a charging and discharging test, thereby enabling a reliable test.

## Description

### [Technical Field]

The present disclosure relates to a jig for a battery charging and discharging test, and more particularly, to a jig for a battery charging and discharging test for fixing a battery to cope with various battery test environments during the battery charging and discharging test.

### [Background Art]

Electric vehicle batteries may be divided into cylindrical, prismatic, and pouch types according to their shape. In the early days, cylindrical batteries were the mainstream as Tesla used cylindrical batteries, but recently, the use of prismatic batteries or pouch-type batteries, which are advantageous for light weight, have high energy density, and can be manufactured in various sizes, is increasing. In particular, the prismatic battery has the advantage of increasing space utilization and providing more flexibility in design.

Lithium iron phosphate batteries, which may be used by charging and discharging electric energy, are mainly used as electric vehicle batteries. In the process of shipping such a battery as a product, a charging and discharging characteristic test is performed to test the performance, lifespan, and safety of the battery while repeating an operation of charging and discharging the battery.

The charging and discharging characteristic test is performed by arranging a plurality of batteries in a chamber, creating an environment inside the chamber as a specific environment, and charging and discharging the battery in the corresponding environment to measure the operating state of the battery. In this case, a jig is used to fix a battery by arranging the battery vertically so that a cathode terminal and an anode terminal of the battery face upward, and a plurality of batteries are put into the chamber together with the jig while being vertically arranged on the jig.

As such, in the related art, since the battery is vertically arranged on the jig and put into the chamber during the charging and discharging characteristic test of the battery, the battery is fixed only vertically and the charging and discharging test is performed, so it is difficult to cope with various battery test environments.

Matters described in the above background art are intended to help the understanding of the background of the invention, and may include matters that are not the disclosed related art.

### [Disclosure]

### [Technical Problem]

An object of the present disclosure is to provide a jig for a battery charging and discharging test that allows the charging and discharging test to be performed by fixing the battery at various angles so as to flexibly cope with various test environments.

Another object of the present disclosure is to provide a jig for a charging and discharging test that improves convenience of use of a worker who fixes a battery and performs a charging and discharging test.

### [Technical Solution]

According to a characteristic of the present disclosure for achieving the object, the present disclosure includes a jig for a battery charging and discharging test, including: a jig body in which a battery is mounted and a battery charging and discharging test is performed, in which the jig body includes: four terminal units that are cross-arranged to face different poles; and a plurality of bus bars that connect two of the four terminal units to the power supply unit crosswise to support the two terminal units, and connect the other two terminal units to the power supply unit horizontally to support the other two terminal units.

The jig body may further include: a main frame; and a mounting frame that is disposed in front of the main frame and on which a battery pack fixing the battery is mounted in a rail manner.

The four terminal units may be installed on a front surface of the main frame and disposed left and right on upper and lower sides of the mounting frame, and may include first and second cathode terminal units and first and second anode terminal units that are cross-arranged so that a first terminal and a second terminal of the battery of the battery pack mounted on the mounting frame are in contact with each other in a vertical direction or in a horizontal direction and face different poles.

The bus bar may include: first and second bus bars that are electrically connected the units for the first and second cathode terminals to the cathode power supply unit; and third and fourth bus bars that are electrically connected the first and second anode terminal units to the cathode power supply unit, and one of the first and second bus bars and one of the third and fourth bus bars are elastically deformable.

A bus bar that connects two of the four terminal units to a power supply unit crosswise to support the two terminal units may be formed to be elastically deformable.

The bus bar that connects two of the four terminal units to a power supply unit crosswise to support the two terminal units may be formed in an S shape.

The jig may further include a first shielding sheet that is disposed between the bus bars to insulate a cathode from an anode.

The jig may further include a second shielding sheet that is disposed to cover the bus bars and insulates the bus bars from the outside.

The jig may further include a unit spacing adjustment means that moves one of the units for the first and second cathode terminals and one of the first and second anode terminal units in a direction close to or away from the rest.

The unit spacing adjustment means may include: a spacing adjusting rod the unit that is disposed between the cathode terminal unit and the anode terminal unit facing each other and have both end portions drawably coupled to a center body; a first gear that is installed on the center body of the spacing adjusting rod; a second gear that rotates the center body by rotating the first gear while being engaged with the first gear; and first and second moving bars that have the both end portions of the spacing adjusting rod each installed to penetrate therethrough and support the both end portions to be drawn out from or drawn in the center body when the center body rotates.

The unit spacing adjustment means further includes: a support shaft rod that is located to be orthogonal to the spacing adjusting rod, has one end provided with the second gear engaged with the first gear, and the other end protruding to one side of the jig body; a handle part that is formed at the other end of the support shaft rod and rotates the support shaft rod; and a fixing lever that is provided on one side of the support shaft rod to fix a state in which the support shaft rod rotates.

The first and second cathode terminal units and the first and second anode terminal units may include a height adjusting means that moves the cathode terminal unit and the anode terminal unit disposed adjacent to each other in a direction close to or away from each other.

The height adjusting means may include: a lift rail that is provided on a first moving plate installed on the main frame; a second moving plate that is provided with a lift plate part installed on a front surface of the first moving plate and moves along the lift rail, and has a support block constituting one of the units for the first and second cathode terminals and the units for the first and second anode terminal units installed on a front surface thereof; and a movable shaft and a movable lever that push the support block toward the mounting frame.

The jig may further include: a rotating means that has one end rotatably coupled to the jig body to serve as a rotation center of the jig body; and a position moving means to which the other end of the rotating means is movably coupled.

### [Advantageous Effects]

According to the present disclosure, since support blocks constituting first and second cathode terminal units and first and second anode terminal units are movable with respect to neighboring support blocks and a distance between the cathode terminal unit and the anode terminal unit facing each other with a mounting frame interposed therebetween can be adjusted, it is possible to reliably fix a battery pack mounted on the mounting frame, and since terminal pins of the cathode terminal unit and the anode terminal unit are stably connected to the first terminal and the second terminal of the battery fixed to the battery pack, it is possible to increase the reliability of electrical connection and increase the reliability of the battery charging and discharging test.

In addition, according to the present disclosure, since a bus bar connecting the first and second cathode terminal units and the first and second anode terminal units to a power supply unit is configured crosswise and horizontally and is elastically deformable, when the units for the first and second cathode terminal and the units for the first and second anode terminal for fixing the battery pack move, it is possible to stably maintain the electrical connection while the movement is flexible.

In addition, according to the present disclosure, it is possible to solve the electrical short problem caused by configuring the bus bars crosswise by installing a shielding sheet between the bus bars, and ensure safety of an operator by securing insulation.

### [Description of Drawings]

FIG. 1 is a perspective view illustrating a jig for a battery charging and discharging test according to an embodiment of the present disclosure.
FIG. 2 is a perspective view illustrating a state in which a battery pack is mounted on the jig for a battery charging and discharging test according to the embodiment of the present disclosure.
FIG. 3 is a perspective view illustrating a state in which the battery pack is mounted in the jig for a battery charging and discharging test according to the embodiment of the present disclosure.
FIG. 4 is a front view of the jig for a battery charging and discharging test according to the embodiment of the present disclosure.
FIG. 5 is a front view illustrating a state in which the jig for a battery charging and discharging test according to the embodiment of the present disclosure rotates.
FIG. 6 is a front view illustrating parts of a cathode terminal unit and an anode terminal unit of the jig for a battery charging and discharging test according to the embodiment of the present disclosure.
FIG. 7 is a perspective view illustrating a state in which the battery pack is mounted on the cathode terminal unit and the anode terminal unit according to the embodiment of the present disclosure.
FIG. 8 is a rear view of the jig for a battery charging and discharging test according to the embodiment of the present disclosure and illustrates a bus bar.
FIG. 9 is a rear view of the jig for a battery charging and discharging test according to the embodiment of the present disclosure and illustrates a unit distance maintenance means.
FIGS. 10 and 11 are rear views of the jig for a battery charging and discharging test according to an embodiment of the present disclosure, and is a diagram illustrating a state in which a shielding sheet is disposed.

***Description of reference numerals***

| | |
|---|---|
| 10: jig for a battery charging and discharging test | 100: jig body |
| 110: main frame | 111: movable rail |
| 113: moving block | 120: mounting frame |
| 121,122: slit groove | 130a, 130b: first and second cathode terminal unit |
| 130c, 130d: first and second anode terminal unit | |
| 131: support block | 132: first moving plate |
| 133: second moving plate | 134: terminal body |
| 135: elastic spring | 136: connection terminal |
| 137: movable shaft | 138: movable lever |
| 139: stop protrusion | 141: battery pack fixing part |
| 150: bus bar | 151, 152, 153, 154: first to fourth bus bar |
| 161: cathode power supply unit | 162: anode power supply unit |
| 170: unit spacing adjustment means | 171: spacing adjusting rod |
| 172: first gear | 173: second gear |
| 174,175: first and second moving bar | 175: support shaft rod |
| 176: handle part | 177: fixing lever |
| 180: height adjusting means | 181: lift rail |
| 182: lift plate part | 191: first shielding sheet |
| 192: 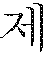 2 shielding sheet | 200: rotating means |
| 201: one end of rotating means | 202: other end of rotating means |
| 205: rotating shaft | 210: handle for rotating jig |
| 300: position moving means | 50: battery pack |
| 51, 52: first and second support cover | 53: fixing means |
| 54: fixing hole | 55: fixing pin |
| 56: seating surface | 57: insertion rib |
| B: battery | a: first terminal |
| b: second terminal | |

### [Best Mode]

Hereinafter, preferred embodiments of the present disclosure will be described in detail with reference to the accompanying drawings.

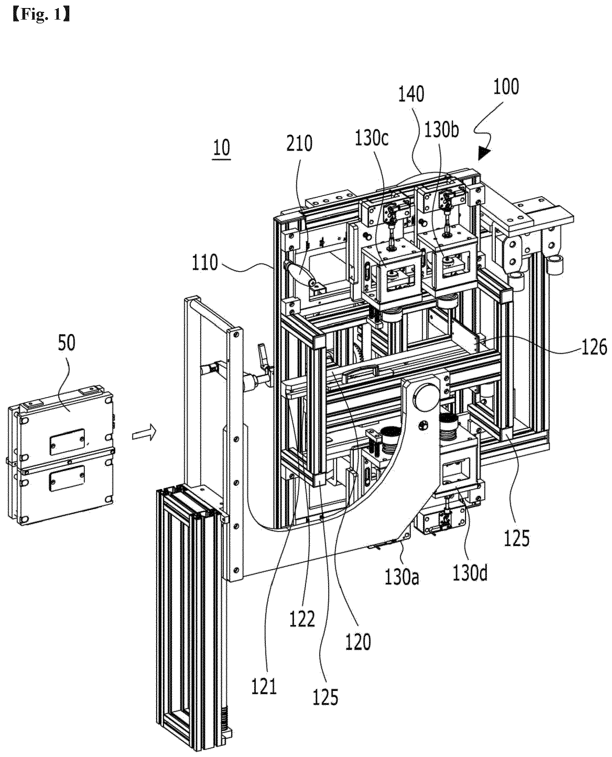

FIG. 1 is a perspective view illustrating a jig for a battery charging and discharging test according to an embodiment of the present disclosure. Since the jig for a battery charging and discharging test of the present disclosure can be used by rotating a jig body, and horizontal and vertical directions vary depending on the installation location, the description of the positional relationship between the horizontal and vertical directions may be ambiguous. Therefore, the jig for a battery charging and discharging test of the present disclosure will be described in terms of vertical and horizontal positional relationships based on the drawing of FIG. 1.

As illustrated in FIG. 1, the jig 10 for a battery charging and discharging test according to an embodiment of the present disclosure includes a jig body 100, a rotating means 200, and a position moving means 300.

The jig body 100 is equipped with a battery B, and the battery charging and discharging test is performed. The battery is mounted on the jig body 100 in the form of a battery pack 50 with support covers coupled to both sides.

One end 201 of the rotating means 200 is rotatably coupled to the jig body 100. One end 201 of the rotating means 200 becomes a rotation center of the jig body 100. The rotating means 200 rotates the jig body 100 so that batteries may be disposed at various angles during a battery charging and discharging test.

The position moving means 300 is movably coupled to the other end 202 of the rotating means 200. The position moving means 300 fixes a jig 10 for a battery charging and discharging test to a ceiling, a wall, a floor, etc., in a chamber for the battery charging and discharging characteristic test, and moves the jig 10 in a certain length range if necessary. The position moving means 300 is formed in the form of a rail so that the other end 202 of the rotating means 200 may be coupled in a rail manner. The position moving means 300 includes a stopper capable of fixing a position where the other end 202 of the rotating means 200 is coupled in a rail manner and moved on the rail. The stopper may be applied in all various forms commonly used.

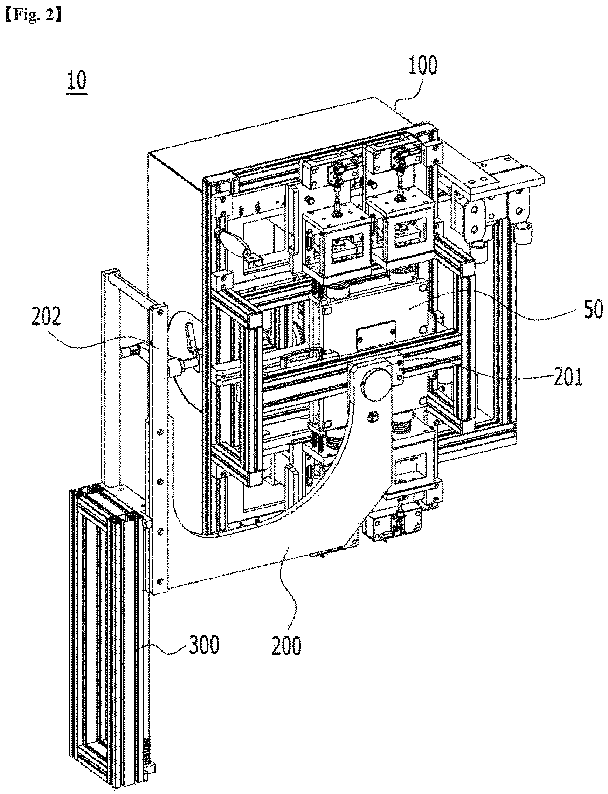

FIG. 2 is a perspective view illustrating a state in which the battery pack is mounted in the jig for a battery charging and discharging test according to the embodiment of the present disclosure.

As illustrated in FIG. 2, the jig body 100 includes a main frame 110, a mounting frame 120, first and second cathode terminal units 130a and 130b, first and second anode terminal units 130c and 130d, and a bus bar 150.

The jig body 100 includes four terminal units 130a, 130b, 130c, and130d cross-arranged to face different poles, and a plurality bus bars 150 that connects two 130a and 130b of the four terminal units 130a, 130b, 130c, and130d to power supply units 161 and 162 crosswise to support the two terminal units 130a and 130b and connects the other two terminal units 130c and 130d to the power supply units 161 and 162 crosswise (horizontally) to support the other two terminal units 130c and 130d. The four terminal units 130a, 130b, 130c, and 130d are supported on the main frame 110.

Specifically, the main frame 110 serves as a basic skeleton for arranging and supporting components constituting the jig 10 for a battery charging and discharging test at appropriate locations. The mounting frame 120, the first and second cathode terminal units 130a and 130b, the first and second anode terminal units 130c and 130d, and the bus bar 150 are disposed and supported on the main frame 110. The main frame 110 may be formed in a rectangular frame shape with the inside open.

The mounting frame 120, the first and second cathode terminal units 130a and 130b, and the first and second anode terminal units 130c and 130d are disposed in front of the main frame 110, and the bus bar 150 is disposed in rear of the main frame 110.

The mounting frame 120 is disposed in the front center portion of the main frame 110. The battery pack 50 is mounted on the mounting frame 120 in a rail manner. The mounting frames 120 are disposed spaced apart from each other in two rows at a front central portion of the main frame 110 and has slit grooves 121 and 122 formed in opposite directions so that the battery pack 50 may mounted in a rail manner. In FIG. 2, the mounting frames 120 may be horizontally disposed spaced apart from each other in two rows at the front central portion of the main frame 110, and the battery pack 50 may be mounted on the mounting frame 120 in a rail manner from the side of the jig body 100.

Both ends of the mounting frame 120 are supported by an auxiliary frame 125. The auxiliary frame 125 is connected to the main frame 110 and supports both ends of the mounting frame 120 so that the mounting frame 120 is stably disposed at the front central portion of the main frame 110.

The mounting frame 120 has one end open and the other end provided with the stopper 126. The battery pack 50 may be inserted into the slit grooves 121 and 122 of the mounting frame 120 in a rail manner through the open end of the mounting frame 120, and the movement of the battery pack 50 inserted into the slit grooves 121 and 122 of the mounting frame 120 in a rail manner is restricted by the stopper 126 so that the state mounted on the mounting frame 120 may be stably maintained. The stopper 126 is formed in a plate shape to contact and support one surface of the battery pack 50 inserted into the slit grooves 121 and 122 in a rail manner by blocking the other end of the mounting frame 120.

The first and second cathode terminal units 130a and 130b, the first and second anode terminal units 130c and 130d are installed on a front surface of the main frame 110 and are disposed left and right on upper and lower sides of the mounting frame 120. In addition, the first and second cathode terminal units 130a and 130b and the first and second anode terminal units 130c and 130d may be cross-arranged to face different poles, and a first terminal a and a second terminal b of the battery pack 50 mounted on the mounting frame 120 may electrically contact each other in a vertical direction or a horizontal direction.

The bus bar 150 connects the first and second cathode terminal units 130a and 130b and the first and second anode terminal units 130c and 130d to the power supply unit.

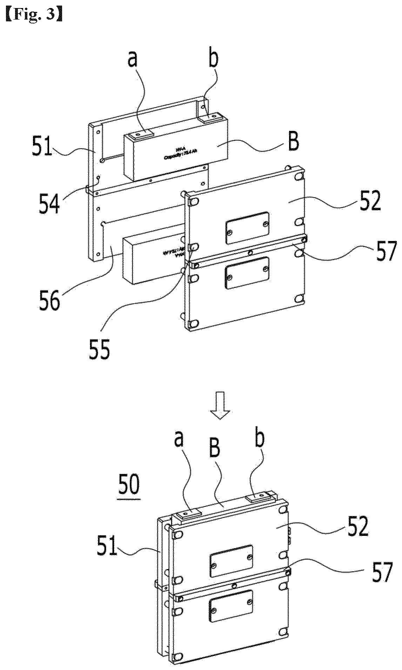

FIG. 3 is a perspective view illustrating a state in which the battery pack is mounted in the jig for a battery charging and discharging test according to the embodiment of the present disclosure.

As illustrated in FIG. 3, the battery pack 50 has a form in which support covers 51 and 52 are coupled to both side walls of the battery B. The support covers 51 and 52 serve as a mounting jig for mounting the battery B on the mounting frame 120 in a rail manner.

The battery B may be formed in a prismatic type and have the first terminal a and the second terminal b provided on one side thereof. Alternatively, the battery may be formed in the prismatic type and have a first terminal provided on one side and a second terminal provided on the other side. In the embodiment, the battery B is formed in the prismatic type, and a battery in which the first terminal a and the second terminal b are provided side by side on one side will be described as an example.

One battery pack 50 may accommodate and support two batteries B. The battery pack 50 includes a first support cover 51, a second support cover 52, and a fixing means 53. The first support cover 51 and the second support cover 52 may come into close contact with one side wall and the other side wall of the two batteries B arranged side by side, respectively, and be mutually fixed by a fixing means 53. The fixing means 53 has fixing pins 55 coupled to fixing holes 54 formed at four corners of the first support cover 51 and the second support cover 52, and may ensure that the first support cover 51 and the second support cover 52 are stably maintained in close contact with one side wall and the other side wall of the two batteries B disposed side by side. A recessed seating surface 56 is formed on an inner surface of at least one of the first support cover 51 and the second support cover 52 so that the two batteries B may be stably fixed between the first support cover 51 and the second support cover 52. The seating surface 56 is formed with one side open so that the first terminal a and the second terminal b of the battery may be exposed to the outside through the open portion, and may be electrically connected to terminal pins of the cathode terminal unit and anode terminal unit. The first and second support covers 52 are made of an insulating material.

Outer surfaces of the first support cover 51 and the second support cover 52 are provided with a protruding bar-shaped insertion rib 57. The insertion rib 57 is formed horizontally long on one side of the outer surfaces of the first support cover 51 and the second support cover 52. The insertion rib 57 is inserted into the slit grooves 121 and 122 of the mounting frame 120. An edge of the end portion of the insertion rib 57 is formed to be rounded, and thus, may be easily inserted into the slit grooves 121 and 122 and moved.

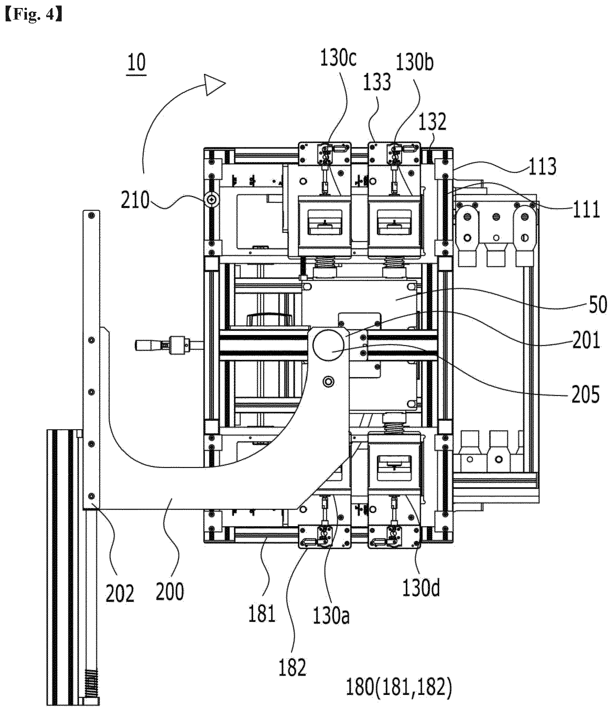

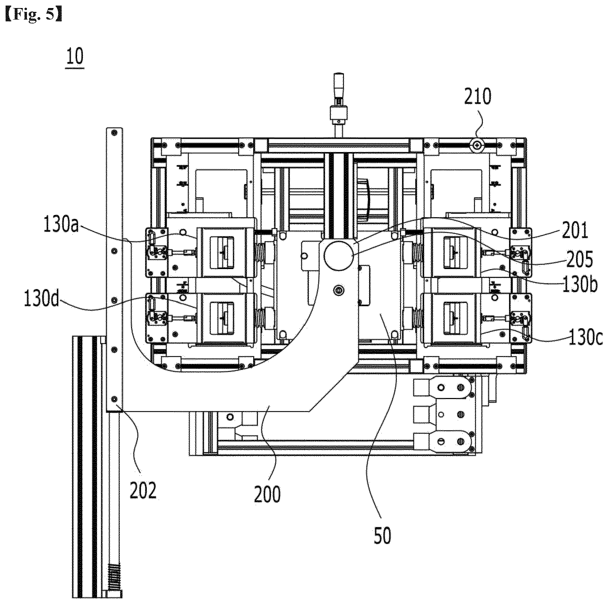

FIG. 4 is a front view of the jig for a battery charging and discharging test according to the embodiment of the present disclosure, and FIG. 5 is a front view illustrating a state in which the jig for a battery charging and discharging test according to the embodiment of the present disclosure rotates.

As illustrated in FIG. 4, one end 201 of the rotating means 200 is coupled to the jig body 100 via a rotating shaft 205. The rotating shaft 205 becomes a rotation center of the jig body 100. When the jig body 100 rotates clockwise around the rotating shaft 205, the jig body 100 can rotate by 90°, 180°, and 270°, and disposed.

In the state of FIG. 4, when the jig body 100 rotates 90° clockwise, as illustrated in FIG. 5, a position of an inlet of the mounting frame 120 into which the battery pack 50 is inserted may change from the side to the top. In addition, the positions of the first and second cathode terminal units 130a and 130b and the first and second anode terminal units 130c and 130d are also change from the structure in which they are disposed left and right on the upper and lower sides of the mounting frame 120 to the structure in which they are disposed vertically on the left and right sides of the mounting frame 120.

When the jig body 100 is rotated by 90°, 180°, 270°, etc., the battery may be disposed at various angles during the battery charging and discharging test to undergo the charging and discharging test.

The main frame 110 is provided with a handle 210 for rotating the jig. The handle 210 for rotating a jig protrudes forward from one side of the front side of the main frame 110 so that an operator may easily grip the jig body 100 to rotate the jig body 100. The handle 210 for rotating the jig may have an outer circumferential surface formed to be rounded and treated with anti-slip.

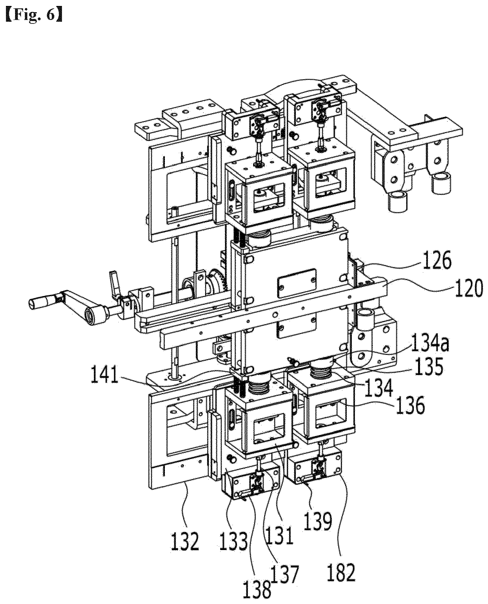

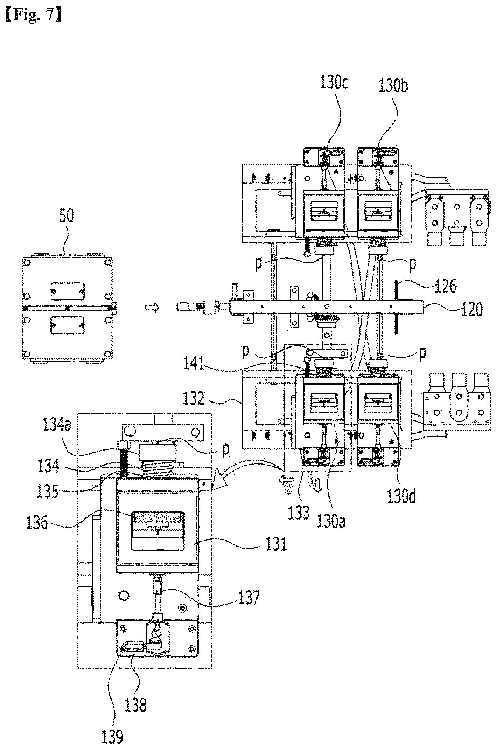

FIG. 6 is a front view illustrating parts of a cathode terminal unit and an anode terminal unit of the jig for a battery charging and discharging test according to the embodiment of the present disclosure, and FIG. 7 is a perspective view illustrating a state in which the battery pack is mounted on the cathode terminal unit and the anode terminal unit according to the embodiment of the present disclosure.

As illustrated in FIG. 6, the first and second cathode terminal units 130a and 130b and the first and second anode terminal units 130c and 130d include a support block 131, a first moving plate 132, a second moving plate 133, a terminal body 134, an elastic spring 135, a connection terminal 136, a movable shaft 137, and a movable lever 138.

The support block 131 is formed in the shape of a hexahedron with an empty interior. The support block 131 is installed on the second moving plate 133 installed on a front surface of the first moving plate 132. The first moving plate 132 is installed on the front surface of the main frame 110 to be movable in the longitudinal direction of the main frame 110 and is movable in a direction away from or close to the mounting frame 120.

Each support block 131 is installed on the second moving plate 133, and two second moving plates 133 are installed on the front surface of the first moving plate 132 to be movable in the longitudinal direction of the first moving plate 132, so the second moving plates is movable in a direction close to or away from a neighboring second moving plate 133 within the first moving plate 132.

The movement of the first moving plate 132 with respect to the main frame 110 serves to widen or narrow the gap between the upper and lower cathode terminal units and anode terminal units based on the mounting frame 120, and the movement of the second moving plate 133 with respect to the first moving plate 132 serves to enable left and right movement of each support block 131.

The terminal body 134 is formed in a cylindrical shape and is installed to penetrate through the support block 131. A tip of the terminal body 134 is exposed in a direction toward the mounting frame 120, and a terminal pin p protrudes from the tip of the terminal body 134. The terminal pin p protruding from the tip of the terminal body 134 is selectively connected to the first terminal a and the second terminal b of the battery pack 50.

The elastic spring 135 is installed on the outer circumferential surface of the terminal body 134 protruding to the outside of the support block 131, and is disposed between the flange 134a at the tip of the terminal body 134 and the support block 131. The elastic spring 135 provides an elastic force in a direction in which the terminal pin p protrudes from the support block 131, so the terminal pin p comes into close contact with the first terminal a or the second terminal b of the battery pack 50 to increase reliability of electrical connection.

A connection terminal 136 is disposed in an empty space inside the support block 131 through the first moving plate 132 and the second moving plate 133. The connection terminal 136 may be connected to the terminal body 134 to supply power to the terminal body 134. For example, the connection terminal 136 may be coupled to an outer circumference of the terminal body 134 disposed in the empty space of the support block 131 and electrically connected to the terminal body 134.

The movable shaft 137 pushes one end of the support block 131 toward the mounting frame 120, so the terminal pin p comes into contact with the first terminal a or the second terminal b of the battery pack 50 mounted on the mounting frame 120.

The movable lever 138 is connected to the movable shaft 137 and moves the movable shaft 137 by pushing or pulling the movable shaft 137. For example, the rotation of the movable lever 138 pulls the movable shaft 137 to pull the support block 131 in a direction away from the mounting frame 120, thereby separating the terminal pin p from the terminal of the battery pack 50. In addition, when the movable lever 138 is returned to the original position, the movable shaft 137 pushes the support block 131 toward the mounting frame 120, so the terminal pin p at the tip of the terminal body 134 moves in a direction in close contact with the terminals a and b of the battery pack 50. This can be applied when the terminal pins of the cathode terminal unit and the anode terminal unit are moved to match the positions of the terminals of the battery pack 50. The rotation of the movable lever 138 may be limited by a stop protrusion 139. The movable lever 138 pushes the movable shaft 137 toward the mounting frame 120 in a state supported by the stop protrusion 139, so the terminal pin p moves in a direction in close contact with the terminal of the battery pack 50.

The support block 131 is movable in direction ① with respect to the second moving plate 133, the second moving plate 133 is movable in direction ② with respect to the first moving plate 132, and the moving plate 132 is movable in the direction ① with respect to the main frame 110.

The movement of the support block 131 in the direction ① with respect to the second moving plate 133 is performed using the movable lever 138, and the movement of the second moving plate 133 in the direction (2) with respect to the first moving plate 132 may be performed by a height adjusting means 180.

The movement of the first moving plate 132 in the direction ① with respect to the main frame 110 may be performed by movable rails 111 formed at the left and right ends of the main frame 110, moving blocks 113 provided at both ends of the first moving plate 132 to be movably coupled to the moving rails 111, and a unit spacing adjustment means 170 to be described later (see FIG. 4).

The movement of the support block 131 in the direction ① with respect to the second moving plate 133 enables individual position control for each support block 131, and the movement of the first moving plate 132 in the direction ① with respect to the main frame 110 enables the position control of the entire support block 131 collectively.

The first and second cathode terminal units 130a and 130b and the first and second anode terminal units 130c and 130d further include a battery pack fixing part 141.

The battery pack fixing part 141 supports both sides of the battery pack 50 mounted on the mounting frame 120, so the state in which the battery pack 50 is mounted on the mounting frame 120 is stably maintained.

The battery pack fixing part 141 is provided on a movably disposed support block 131 among the first and second cathode terminal units 130a and 130b and the first and second anode terminal units 130c and 130d. The battery pack fixing part 141 is formed to protrude from the support block 131 in the direction of the mounting frame 120 and closely supports both sides of the battery pack 50 mounted on the mounting frame 120 by applying a spring. As a result, one surface (bottom surface) of the battery pack 50 mounted on the mounting frame 120 is supported by the stopper 126 and both sides thereof are supported by the battery pack fixing part 141, so the state in which the battery pack 50 is mounted on the mounting frame 120 is stably maintained, and the battery charging and discharging test may be performed at an accurately fixed position.

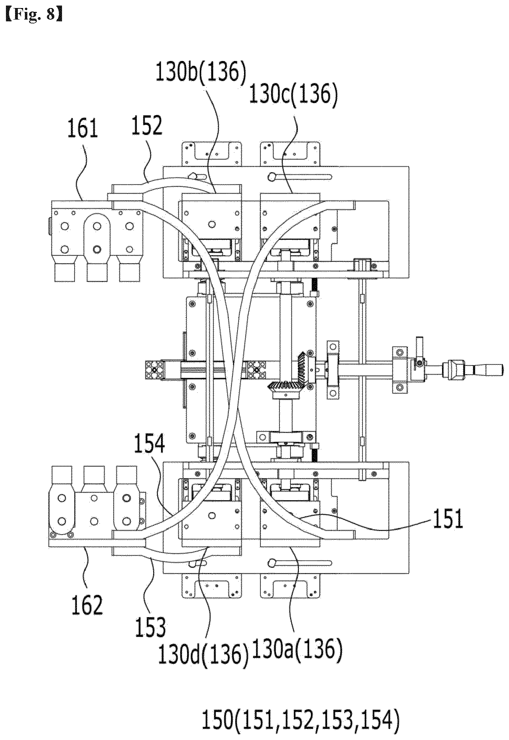

FIG. 8 is a rear view of the jig for a battery charging and discharging test according to the embodiment of the present disclosure and illustrates a bus bar.

As illustrated in FIG. 8, the jig for a battery charging and discharging test includes the bus bar 150 connecting the first and second cathode terminal units 130a and 130b and the first and second anode terminal units 130c and 130d to the power supply units 161 and 162, and the bus bar 150 is disposed at the rear of the main frame 110.

One end of the bus bar 150 is disposed to protrude into the empty space of each support block 131 and the rest is connected to each connection terminal 136 exposed to the rear surface of the main frame 110 to supply power. That is, a plate-shaped connection terminal 136 is provided on the rear surface of each support block 131, and one end of the connection terminal 136 extends into the empty space inside the support block 131 to be connected to the terminal body 134.

The bus bar 150 includes a first bus bar 151, a second bus bar 152, a third bus bar 153, and a fourth bus bar 154. The first bus bar 151 connects the connection terminal 136 of the first cathode terminal unit 130a to the cathode power supply unit 161, and the second bus bar 152 connects the connection terminal 136 of the second cathode terminal unit 130b to the cathode power supply unit 161. The third bus bar 153 connects the connection terminal 136 of the first anode terminal unit 130c to the anode power supply unit 162. The fourth bus bar 154 connects the connection terminal 136 of the second anode terminal unit 130d to the anode power supply unit 162.

The first bus bar 151 to the fourth bus bar 154 may be formed to be elastically deformable.

Preferably, one of the first and second bus bars 151 and 152 and one of the third and fourth bus bars 153 and 154 are formed to be elastically deformable. That is, the bus bar 150 connecting one of the first and second cathode terminal units 130a and 130b and one of the first and second anode terminal units 130c and 130d to the power supply units 161 and 162 is formed to be elastically deformable.

For example, one of the first and second bus bars 151 and 152 and one of the third and fourth bus bars 153 and 154 are formed in an S shape. In the embodiment, the first bus bar 151 connects the connection terminal 136 of the first cathode terminal unit 130a to the cathode power supply unit 161 in an S shape, and the fourth bus bar 154 connects the connection terminal 136 of the first anode terminal unit 130c to the anode power supply unit 162 in an S shape. This is because the first cathode terminal unit 130a and the first anode terminal unit 130c is configured to be movable in a direction close to or away from the second anode terminal unit 130d and the second cathode terminal unit 130b, and the second anode the terminal unit 130d and the second cathode terminal unit 130b have a fixed configuration. That is, this is to ensure that the first cathode terminal unit 130a and the first anode terminal unit 130c freely move within a certain stroke and can also supply power while the bus bar 150 is deformed according to the movement of the first cathode terminal unit 130a and the first anode terminal unit 130c.

More specifically, when the first cathode terminal unit 130a and the first anode terminal unit 130c move in a direction close to or away from the second anode terminal unit 130d and the second cathode terminal unit 130b, the first bus bar 151 and the fourth bus bar 154 are elastically deformed to enable the movement of the first cathode terminal unit 130a and the second anode terminal unit 130d. The S-shaped first bus bar 151 and the fourth bus bar 154 are made to have a structure in which the first cathode terminal unit 130a and the first anode terminal unit 130c are movable and can supply power.

When the first cathode terminal unit 130a and the first anode terminal unit 130c move in a direction close to the second anode terminal unit 130d and the second cathode terminal unit 130b, the elastic force acts in a direction in which an S-shaped bend is formed, and when the first cathode terminal unit 130a and the first anode terminal unit 130c move in a direction away from the second anode terminal unit 130d and the second cathode terminal unit 130b, the elastic force acts in the shape that the S-shaped curve is stretched.

Since the second cathode terminal unit 130b and the second anode terminal unit 130d are movable only in a direction in which the width between the two is widened, and configured not to move in a direction close to or away from the first cathode terminal unit 130a and the first anode terminal unit 130c, the bus bar having an elastically deformable structure is not used.

For example, the second bus bar 152 connecting the second cathode terminal unit 130b to the cathode power supply unit 161 and the third bus bar 153 connecting the second anode terminal unit 130d to the anode power supply unit 162 may be formed only in a straight line shape or a shape in which at least a portion has a predetermined curved surface.

The first to fourth bus bars 154 serve to supply power to first and second cathode terminal units 130a and 130b and first and second anode terminal units 130c and 130d, respectively. The first to fourth bus bars 154 are made of a conductive material.

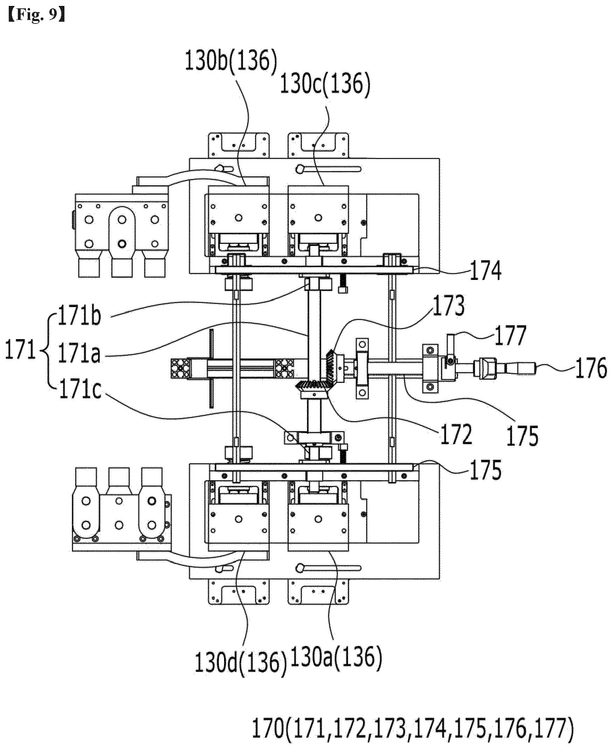

FIG. 9 is a rear view of the jig for a battery charging and discharging test according to the embodiment of the present disclosure and illustrates a unit distance maintenance means.

As illustrated in FIG. 9, the jig 10 for a battery charging and discharging test according to an embodiment of the present disclosure further includes the unit spacing adjustment means 170.

The unit spacing adjustment means 170 moves one of the first and second cathode terminal units 130a and 130b and one of the first and second anode terminal units 130c and 130d in the direction close to or away from the rest. That is, the cathode terminal unit and the anode terminal unit facing each other with the mounting frame 120 interposed therebetween move in the direction close to or away from each other.

The battery pack 50 is mounted on the mounting frame 120 in a rail manner while the cathode terminal unit and the anode terminal unit facing each other with the mounting frame 120 interposed therebetween are away from each other, the battery pack 50 may be stably fixed by bringing the cathode terminal unit and the anode terminal unit facing each other closer to each other with the mounting frame 120 interposed therebetween when the bottom surface of the battery pack 50 comes into contact with the stopper 126, and each terminal pin p may be connected to the first terminal a and the second terminal b of the battery pack 50.

The unit spacing adjustment means 170 includes a spacing adjusting rod 171, a first gear 172, a second gear 173, and first and second moving bars 174 and 175.

The spacing adjusting rod 171 is located between the cathode terminal units 130a and 130b and the anode terminal units 130c and 130d facing each other, and draw-out rods 171b and 171c of both end portions are combined to be drawn out from the center body 171a. The draw-out rods 171b and 171c of the spacing adjusting rod 171 are screwed to both end portions of a center body 171a, and their rotation is limited by the first and second moving bars 174 and 175 to be described later, so the draw-out rods 171b and 171 may be drawn out from both end portions of the center body 171a when the center body 171a rotates. In the embodiment, the spacing adjusting rod 171 is located between the first cathode terminal unit 130a and the first anode terminal unit 130c facing each other, so the spacing between the cathode terminal units 130a and 130b and the anode terminal units 130c and 130d is adjusted while the draw-out rods 171b and 171c of both end portions are drawn out or drawn in.

The first gear 172 is installed on the center body 171a of the spacing adjusting rod 171. When the first gear 172 rotates, the center body 171a rotates. The second gear 173 rotates the center body 171a by rotating the first gear 172 while being engaged with the first gear 172.

Both end portions of the spacing adjusting rod 171 are installed to penetrate through the first and second moving bars 174 and 175, respectively, and when the center body 171a rotates, the draw-out rods 171b and 171c of both end portions are supported to be drawn out from and drawn in the center body 171a. The first and second moving bars 174 and 175 are moved together as the draw-out rods 171b and 171c of both end portions of the spacing adjusting rod 171 are integrally fixed.

When the first gear 172 rotates by the rotation of the second gear 173, the center body 171a rotates, and the rotation of the center body 171a allows the first and second moving bars 174 and 175 to be drawn out from and drawn in the center body 171a to move the first and second moving bars 174 and 175. Since the first and second moving bars 174 and 175 are each fixed to the first moving plate 132 disposed on both sides of the mounting frame 120, the movement of the first and second moving bars 174 and 175 may move the first moving plate 132, and the first and second moving bars 174 and 175 may move the cathode terminal unit and the anode terminal unit facing each other in a direction close to or away from each other with the mounting frame 120 therebetween.

The second gear 173 is installed on the support shaft rod 175. The support shaft rod 175 protrudes to one side of the jig body 100 and a handle part is formed on its end portion so that an operator may grip the handle part to rotate the support shaft rod 175. The rotation of the support shaft rod 175 may rotate the second gear 173 and the first gear 172. The support shaft rod 175 is located to be orthogonal to the spacing adjusting rod 171.

The support shaft rod 175 further includes a fixing lever 177 that fixes the rotated state. The fixing lever 177 presses a part of the outer circumferential surface of the support shaft rod 175 to fix the rotated state of the support shaft rod 175.

Also, referring to FIGS. 4, 5 and 7, the jig 10 for a charging and discharging test further includes a height adjusting means 180.

The height adjusting means 180 includes a lift rail 181 provided on the first moving plate 132 and a lift plate part 182 provided on the second moving plate 133. As the lift plate part 182 of the second moving plate 133 moves along the lift rail 181 of the first moving plate 132, the spacing between neighboring second moving plates 133 may be adjusted.

The moved position of the second moving plate 133 may be fixed in a state where the battery pack fixing part 141 is in close contact with the battery pack 50 and the terminal pin p is connected to the terminal of the battery pack 50. This fixing is performed by interlocking with the movable lever 138. By rotating the movable lever 138, the moved position of the lift plate part 182 on the lift rail 181 is fixed, and by returning the rotated state of the movable lever 138 to its original position, the lift plate part 182 may freely move to the lift rail 181. To this end, the movable lever 138 and the movable shaft 137 are installed on the front surface of the lift plate part 182, and move along the lift rail 181 on the rear surface of the lift plate part 182, and may be provided with a protruding part that operates to be in close contact with or hung on the lift rail according to the operation of the movable lever 138.

On the other hand, in the embodiment, the configuration in which the first cathode terminal unit 130a and the second anode terminal unit 130d are movable in a direction away from or closer to the second anode terminal unit 130d and the second cathode terminal unit 130b, and the second anode terminal unit 130d and the second cathode terminal unit 130b are fixed has been described, but similarly to the first cathode terminal unit 130a and the second anode terminal unit 130d, the second anode terminal unit 130d and the second cathode terminal unit 130b are also movable along the lift rail 181 of the first moving plate 132.

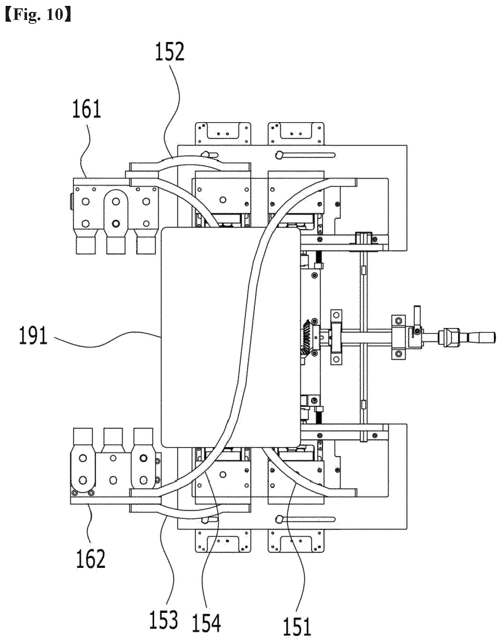

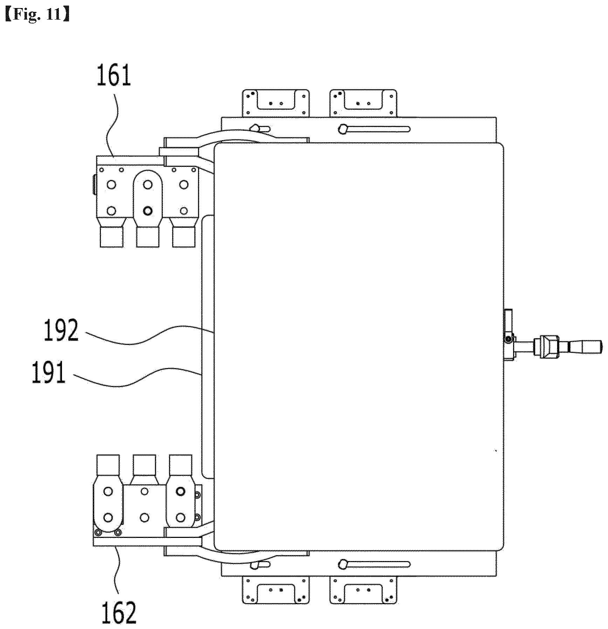

FIGS. 10 and 11 are rear views of the jig for a battery charging and discharging test according to an embodiment of the present disclosure, and is a diagram illustrating a state in which a shielding sheet is disposed.

As illustrated in FIGS. 10 and 11, the jig 10 for a battery charging and discharging test according to the embodiment of the present disclosure further includes shielding sheets 191 and 192. The shielding sheets 191 and 192 include a first shielding sheet 191 and a second shielding sheet 192 formed in a plate shape having a predetermined area.

The first shielding sheet 191 is disposed between the first and second bus bars 151 and 152 and the third and fourth bus bars 153 and 154 to insulate the cathode and the anode. For example, the first shielding sheet 191 is disposed between the first bus bar 151 and the fourth bus bar 154. The first bus bar 151 and the fourth bus bar 154 are formed in an S shape and disposed crosswise, but are spaced apart from each other, and the first shielding sheet 191 is disposed in the spaced space between the first bus bar 151 and the fourth bus bar 154.

The second shielding sheet 192 is disposed to cover the bus bars 150 to insulate the bus bars 150 from the outside to prevent an electric shock accident or the like during the operation of the operator. The first shielding sheet 191 and the second shielding sheet 192 may be ferrite sheets or may be made of a material having an insulating function.

The jig 10 for a battery charging and discharging test according to the embodiment of the present disclosure further includes the unit spacing adjustment means 170.

The unit spacing adjustment means 170 moves one of the first and second cathode terminal units 130a and 130b and one of the first and second anode terminal units 130c and 130d in the direction close to or away from the rest.

The unit spacing adjustment means 170 includes a spacing adjusting rod 171, a first gear 172, a second gear 173, and first and second moving bars 174 and 175.

The spacing adjusting rod 171 is located between the cathode terminal units 130a and 130b and the anode terminal units 130c and 130d facing each other, and has a shape in which both end portions are drawn out from the center body 171a.

The first gear 172 is installed on the center body 171a of the spacing adjusting rod 171.

The second gear 173 rotates the center body 171a by rotating the first gear while being engaged with the first gear 172.

Both end portions of the spacing adjusting rod 171 are installed to penetrate through the first and second moving bars 174 and 175, respectively, and when the center body 171a rotates, the draw-out rods 171b and 171c of both end portions are supported to be drawn out from and drawn in the center body 171a. That is, the first and second moving bars 174 and 175 move together as both end portions of the spacing adjusting rod 171 are integrally fixed.

The operation of the present disclosure will be described below.

Referring to FIGS. 2 and 4, in the jig 10 for a battery charging and discharging test according to the embodiment of the present disclosure, the battery pack 50 in which two batteries are fixed is mounted on the mounting frame 120. Two batteries B fixed to the battery pack 50 are electrically connected to the cathode terminal unit and the anode terminal unit arranged side by side with the first terminal a and the second terminal b of each battery B exposed on one side.

That is, in FIG. 4, the first terminal and the second terminal b of the battery fixed to the lower side of the battery pack 50 are connected to the terminal pins p of the first cathode terminal unit 130a and the second anode terminal unit 130d, respectively, and the first terminal a and the second terminal b of the battery fixed to the upper side in the battery pack 50 are connected to the terminal pins p of the first anode terminal unit 130c and the second cathode terminal unit 130b, respectively. Therefore, the battery charging and discharging test may be performed by mounting two batteries B in one jig 10 for a battery charging and discharging test.

When the battery pack 50 is mounted on the mounting frame 120, by a method of moving the first moving plate 132 in the direction CD with respect to the main frame 110, moving the second moving plate 133 in the direction (2) with respect to the first moving plate 132, or moving the support block 131 in the direction ① with respect to the second moving plate 133, the battery pack 50 may be stably seated on the mounting frame 120 and the terminal pins p of each cathode terminal unit 130a and 130b and anode terminal unit 130c and 130d may be reliably connected to the first terminal a and the second terminal b of each battery.

In the process of moving the first moving plate 132 in the direction ① with respect to the main frame 110 or moving the second moving plate 133 in the direction (2) with respect to the first moving plate 132, the bus bar 150 supplying power to the terminal units 130a and 130b and the anode terminal units 130c and 130d enables the movement of the cathode terminal units 130a and 130b and the anode terminal units 130c and 130d while being elastically deformed.

In the above method, when the battery pack 50 is stably mounted in the correct position of the mounting frame 120, the battery charging and discharging test may be performed by supplying power to each of the cathode terminal units 130a and 130b and the anode terminal units 130c and 130d through the bus bar 150.

According to the present disclosure described above, the battery can be accurately fixed and the operation is simple, so the convenience of the operator performing the charging and discharging test can be improved and the reliable testing can be performed.
The spirit of the present disclosure has been illustratively described hereinabove. It will be appreciated by those skilled in the art that various modifications and alterations may be made without departing from the essential characteristics of the present disclosure. Accordingly, exemplary embodiments disclosed in the present disclosure are not to limit the spirit of the present disclosure, but are to describe the spirit of the present disclosure. The scope of the present disclosure is not limited to these exemplary embodiments. The scope of the present disclosure should be interpreted by the following claims, and it should be interpreted that all the spirits equivalent to the following claims fall within the scope of the present disclosure.

## Claims

1. A jig for a battery charging and discharging test, comprising:
a jig body in which a battery is mounted and a battery charging and discharging test is performed;
wherein the jig body includes:
four terminal units that are cross-arranged to face different poles; and
a plurality of bus bars that connect two of the four terminal units to the power supply unit crosswise to support the two terminal units, and connect the other two terminal units to the power supply unit horizontally to support the other two terminal units.

2. The jig of claim 1, wherein the jig body further includes:
a main frame; and
a mounting frame that is disposed in front of the main frame and on which a battery pack fixing the battery is mounted in a rail manner.

3. The jig of claim 2, wherein the four terminal units are installed on a front surface of the main frame and are disposed left and right on upper and lower sides of the mounting frame, and includes first and second cathode terminal units and first and second anode terminal units that are cross-arranged so that a first terminal and a second terminal of the battery of the battery pack mounted on the mounting frame are in contact with each other in a vertical direction or in a horizontal direction and face different poles.

4. The jig of claim 3, wherein the bus bar includes:
first and second bus bars that are electrically connected the units for the first and second cathode terminals to the cathode power supply unit; and
third and fourth bus bars that are electrically connected the first and second anode terminal units to the cathode power supply unit, and
one of the first and second bus bars and one of the third and fourth bus bars are elastically deformable.

5. The jig of claim 1, wherein a bus bar that connects two of the four terminal units to a power supply unit crosswise to support the two terminal units is formed to be elastically deformable.

6. The jig of claim 1, wherein the bus bar that connects two of the four terminal units to a power supply unit crosswise to support the two terminal units is formed in an S shape.

7. The jig of claim 1, further comprising:
a first shielding sheet that is disposed between the bus bars to insulate a cathode from an anode.

8. The jig of claim 1, further comprising:
a second shielding sheet that is disposed to cover the bus bars and insulates the bus bars from the outside.

9. The jig of claim 3, further comprising:
a unit spacing adjustment means that moves one of the units for the first and second cathode terminals and one of the first and second anode terminal units in a direction close to or away from the rest.

10. The jig of claim 9, wherein the unit spacing adjustment means includes:
a spacing adjusting rod the unit that is disposed between the cathode terminal unit and the anode terminal unit facing each other and have both end portions drawably coupled to a center body;
a first gear that is installed on the center body of the spacing adjusting rod;
a second gear that rotates the center body by rotating the first gear while being engaged with the first gear; and
first and second moving bars that have the both end portions of the spacing adjusting rod each installed to penetrate therethrough and support the both end portions to be drawn out from or drawn in the center body when the center body rotates.

11. The jig of claim 10, wherein the unit spacing adjustment means further includes:
a support shaft rod that is located to be orthogonal to the spacing adjusting rod, has one end provided with the second gear engaged with the first gear, and the other end protruding to one side of the jig body;
a handle part that is formed at the other end of the support shaft rod and rotates the support shaft rod; and
a fixing lever that is provided on one side of the support shaft rod to fix a state in which the support shaft rod rotates.

12. The jig of claim 3, wherein the first and second cathode terminal units and the first and second anode terminal units include a height adjusting means that moves the cathode terminal unit and the anode terminal unit disposed adjacent to each other in a direction close to or away from each other.

13. The jig of claim 12, wherein the height adjusting means includes:
a lift rail that is provided on a first moving plate installed on the main frame;
a second moving plate that is provide with a lift plate part installed on a front surface of the first moving plate and moves along the lift rail, and has a support block constituting one of the units for the first and second cathode terminals and the units for the first and second anode terminal units installed on a front surface thereof; and
a movable shaft and a movable lever that push the support block toward the mounting frame.

14. The jig of claim 1, further comprising:
a rotating means that has one end rotatably coupled to the jig body to serve as a rotation center of the jig body; and
a position moving means to which the other end of the rotating means is movably coupled.
